# EUROPEAN PATENT APPLICATION

(11) **EP 4 120 349 A1**
(43) Date of publication of application: **18.01.2023**
(21) Application number: 21767253.4
(22) Date of filing: 08.03.2021
(51) Int. Cl.: H01L 27/15, H01L 33/54, H01L 33/50, H01L 33/10, H01L 33/60, F21K 9/60, F21S 41/141, F21S 43/14

(54) **LIGHTING MODULE AND LIGHTING DEVICE COMPRISING SAME**

(30) Priority: 09.03.2020 KR 20200029153
(71) Applicant: LG Innotek Co., Ltd., Seoul 07796 (KR)
(72) Inventor: EOM, Dong Il, Seoul 07796 (KR)
(74) Representative: Plasseraud IP
(86) International application number: PCT/KR2021/002851
(87) International publication number: WO 2021/182826

(57) **Abstract**

The lighting module disclosed in the embodiment includes a circuit board; a plurality of first light emitting devices disposed on a first region of the circuit board; a plurality of second light emitting devices disposed on a second region of the circuit board; a resin layer including a first resin portion sealing the first light emitting devices and a second resin portion sealing the second light emitting devices; a phosphor portion disposed between the first and second resin portions; a diffusion layer disposed on the first resin portion; and a reflective layer disposed on an upper surface and an outer side surface of the second resin portion, wherein each of the first light emitting devices and the second light emitting devices has at least one row in a first direction, and are arranged in a second direction orthogonal to the first direction, and a width of the second resin portion in the first direction may be smaller than a width of the first resin portion.

## Description

### [Technical Field]

An embodiment of the invention relates to a lighting module that provides light of different colors.

An embodiment of the invention relates to a lighting device having a lighting module, a light unit, or a vehicle lamp.

### [Background Art]

Light emitting diodes (LEDs) have advantages such as low power consumption, semi-permanent lifespan, fast response speed, safety, and environmental friendliness compared to conventional light sources such as fluorescent lamps and incandescent lamps. Such light emitting diodes are being applied to various lighting devices such as various display devices, indoor lights or outdoor lights. Recently, as a light source for a vehicle, a lamp employing a light emitting diode has been proposed. Compared with an incandescent lamp, a light emitting diode is advantageous in that power consumption is small. In addition, since the light emitting diode is small in size, it can increase the design freedom of the lamp, and it is also economical due to its semi-permanent lifespan.

### [Disclosure]

### [Technical Problem]

An embodiment of the invention may provide a lighting module that provides a plurality of color lights.

An embodiment of the invention may provide a lighting module capable of selectively emitting light from a first light emitting device overlapping the light emission region in a vertical direction and light from a second light emitting device not overlapping with the light emission region in the vertical direction. An embodiment of the invention provides a lighting module capable of emitting light of at least three colors using at least two light sources. An embodiment of the invention may provide a lighting module irradiating surface light of different colors, a lighting device having the same, a light unit, a liquid crystal display device, or a vehicle lamp.

### [Technical Solution]

A lighting module according to an embodiment of the invention, a circuit board; a plurality of first light emitting devices disposed on a first region of the circuit board; a plurality of second light emitting devices disposed on a second region of the circuit board; a resin layer including a first resin portion sealing the plurality of first light emitting devices and a second resin portion sealing the plurality of second light emitting devices; a phosphor portion disposed between the first resin portion and the second resin portion; a diffusion layer disposed on the first resin portion; and a reflective layer disposed on an upper surface and an outer side surface of the second resin portion, wherein each of the plurality of first light emitting devices and the plurality of second light emitting devices has at least one row in a first direction, and are arranged in a second direction orthogonal to the first direction, and a width of the second resin portion in the first direction may be smaller than a width of the first resin portion.

According to an embodiment of the invention, the first light emitting device includes a first light emitting chip for emitting blue light; and a wavelength conversion layer disposed on a surface of the first light emitting chip, wherein the first light emitting device may emit white light. According to an embodiment of the invention, the second light emitting device may emit blue light, and the phosphor portion may cover between the first resin portion and the second resin portion and may emit red or yellow light. The lighting module according to another embodiment of the invention, a circuit board; a plurality of first light emitting devices disposed on a first region of the circuit board; a plurality of second light emitting devices disposed on a second region of the circuit board; a resin layer including a first resin portion sealing the plurality of first light emitting devices and a second resin portion sealing the plurality of second light emitting devices; a phosphor layer disposed on the first resin portion; an ink layer disposed on the phosphor layer; and a reflective layer disposed on an upper surface and an outer side surface of the second resin portion, wherein each of the plurality of first light emitting devices and the plurality of second light emitting devices has at least one row in a first direction, and are arranged in a second direction orthogonal to the first direction, and a width of the second resin portion in the first direction may be smaller than a width of the first resin portion. According to an embodiment of the invention, the first light emitting device emits blue light, and the second light emitting device includes a second light emitting chip that emits blue light; and a wavelength conversion layer disposed on a surface of the second light emitting chip, wherein the second light emitting device may emit white light. According to an embodiment of the invention, the phosphor layer may include a red phosphor, and the ink layer may include red ink particles. The width of the first resin portion in the first direction may be at least twice the width of the second resin portion in the first direction, or in a range of 5 mm to 15 mm. According to another embodiment of the invention, a light emission region in which light is emitted on the first resin portion and a non-emission region in which light is reflected on the second resin portion are provided, and the non-emission region are disposed on both sides of the light emission region. According to another embodiment of the invention, a light emission region in which light is emitted on the first resin portion and a non-emission region in which light is reflected on the second resin portion are provided, and the light emission region is disposed on both sides of the non-emission region. According to another embodiment of the invention, a reflective member may be included between the resin layer and the circuit board, and the reflective member may be in contact with the reflective layer.

### [Advantageous Effects]

According to an embodiment of the invention, light of different colors may be provided to the same light emission region in the lighting module. According to an embodiment of the invention, a light emitting portion and a non-light emitting portion may be provided, and light emitted from the light emitting portion and the non-light emitting portion may be emitted through the surface of the light emitting portion. Embodiments of the invention may improve the light efficiency and light distribution characteristics of the lighting module. Embodiments of the invention may reduce the difference in chromaticity between the exterior image of the resin layer of the lighting module and the light emitting image. An embodiment of the invention may improve the color of a lamp according to whether it is turned on or off. It is possible to improve the optical reliability of the lighting module and the lighting device or vehicle lamp having the same according to an embodiment of the invention. Embodiments of the invention may be applied to a light unit having a lighting module, various types of display devices, a surface light source lighting device, or a vehicle lamp.

### [Description of Drawings]

FIG. 1 is a plan view showing a lighting module according to a first embodiment of the invention.
FIG. 2 is a side cross-sectional view taken along line A-A of the lighting module of FIG. 1.
FIG. 3 is a first modified example of the lighting module of FIG. 2.
FIG. 4 is a side cross-sectional view taken along line B-B of the lighting module of FIG. 1.
FIG. 5 is a side cross-sectional view taken along line C-C of the lighting module of FIG. 1.
FIG. 6 is a second modified example of the lighting module of FIG. 2.
FIG. 7 is a third modified example of the lighting module of FIG. 2.
FIG. 8 is a side cross-sectional view of a lighting module according to a second embodiment of the invention.
FIG. 9 is a first modified example of the lighting module of FIG. 8.
FIG. 10 is a second modified example of the lighting module of FIG. 8.
FIG. 11 is a third modified example of the lighting module of FIG. 8.
FIG. 12 is a lighting module according to a modified example of the first embodiment of the invention, and is an example of a plan view having a plurality of light emitting portions.
FIG. 13 is an example of a plan view of a lighting module according to a modified example of the first embodiment of the invention, which has a plurality of reflective portions.
FIG. 14 is an example of a plan view of a lighting module according to a modified example of the second embodiment of the invention, which has a plurality of light emitting portions.
FIG. 15 is an example of a plan view of a lighting module according to a modified example of the second embodiment of the invention, which has a plurality of reflective portions.
FIG. 16 is another example of the invention, and is a modified example of a light emitting portion and a reflective portion in the lighting module according to the first and second embodiments.
FIG. 17 is another example of the invention, and is a modified example of a phosphor portion in the lighting module according to the first and second embodiments.
FIG. 18 is another example of the invention, and is a modified example of the first light emitting device in the lighting module according to the first and second embodiments.
FIG. 19 is an example of a side cross-sectional view having the first light emitting device of FIG. 18.
FIG. 20 is a plan view of a vehicle to which a lamp having a lighting module according to an embodiment of the invention is applied.
FIG. 21 is an example of a front lighting device of a vehicle according to an embodiment of the invention.
FIG. 22 is a view showing an example of a rear lighting device for a vehicle according to an embodiment of the invention.

### [Best Mode]

Hereinafter, preferred embodiments of the invention will be described in detail with reference to the accompanying drawings. The technical spirit of the invention is not limited to some embodiments to be described, and may be implemented in various other forms, and one or more of the components may be selectively combined and substituted for use within the scope of the technical spirit of the invention. In addition, the terms (including technical and scientific terms) used in the embodiments of the invention, unless specifically defined and described explicitly, may be interpreted in a meaning that may be generally understood by those having ordinary skill in the art to which the invention pertains, and terms that are commonly used such as terms defined in a dictionary should be able to interpret their meanings in consideration of the contextual meaning of the relevant technology. Further, the terms used in the embodiments of the invention are for explaining the embodiments and are not intended to limit the invention. In this specification, the singular forms also may include plural forms unless otherwise specifically stated in a phrase, and in the case in which at least one (or one or more) of A and (and) B, C is stated, it may include one or more of all combinations that may be combined with A, B, and C. In describing the components of the embodiments of the invention, terms such as first, second, A, B, (a), and (b) may be used. Such terms are only for distinguishing the component from other component, and may not be determined by the term by the nature, sequence or procedure etc. of the corresponding constituent element. And when it is described that a component is "connected ", "coupled" or "joined" to another component, the description may include not only being directly connected, coupled or joined to the other component but also being "connected ", "coupled" or "joined" by another component between the component and the other component. In addition, in the case of being described as being formed or disposed "above (on)" or "below (under)" of each component, the description includes not only when two components are in direct contact with each other, but also when one or more other components are formed or disposed between the two components. In addition, when expressed as "above (on)" or "below (under)", it may refer to a downward direction as well as an upward direction with respect to one element.

The lighting device according to the invention may be applied to various lamp devices that require lighting, such as vehicle lamps, home lighting devices, or industrial lighting devices. For example, when applied to vehicle lamps, it is applicable to headlamps, sidelights, side mirrors, fog lights, tail lamps, brake lights, daytime running lights, vehicle interior lights, door scars, rear combination lamps, backup lamps, etc. The lighting device of the invention may be applied to indoor and outdoor advertising devices, display devices, and various electric vehicle fields, and in addition, it may be applied to all lighting-related fields or advertisement-related fields that are currently developed and commercialized or that may be implemented according to future technological developments.

### <First embodiment>

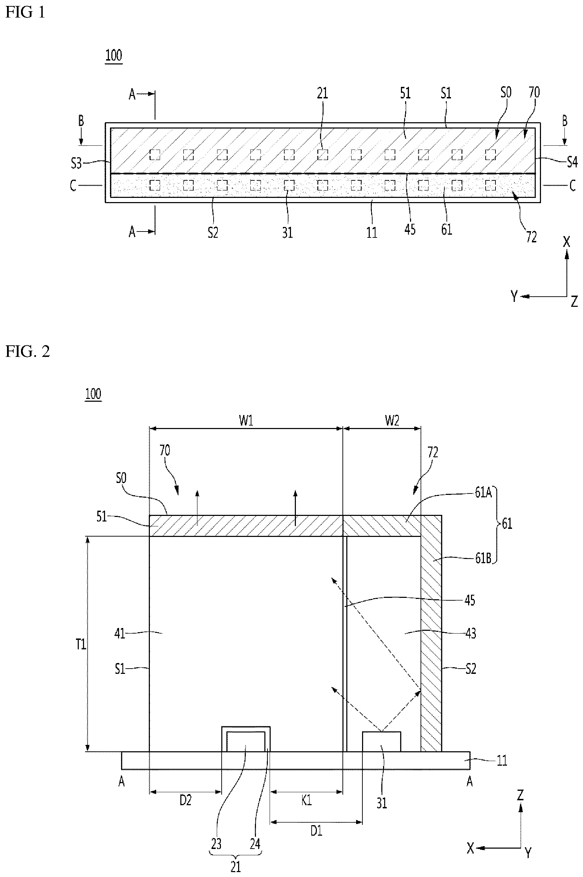

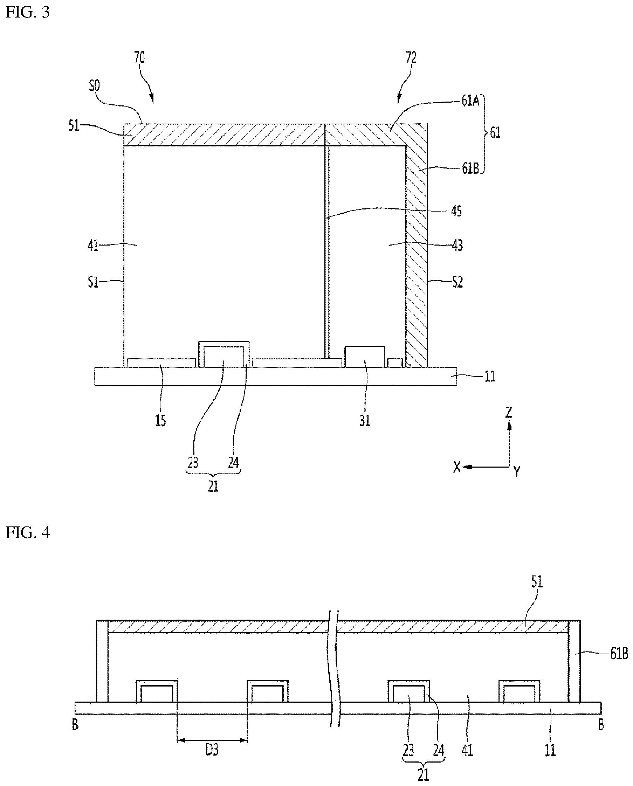

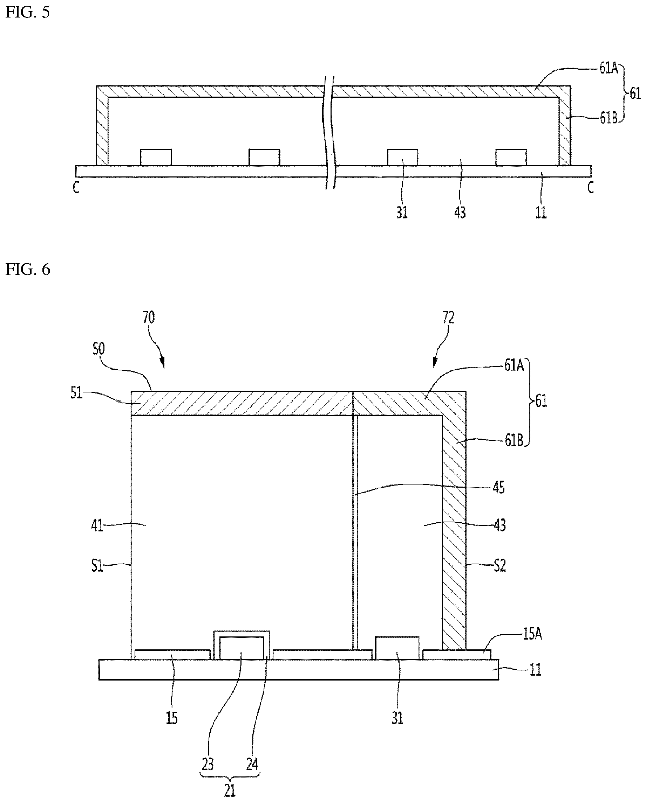

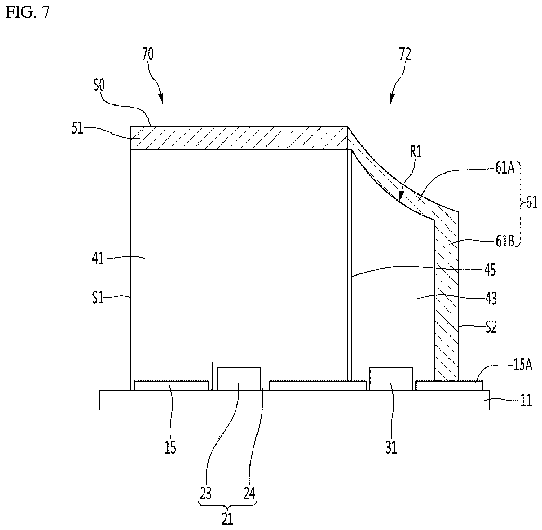

FIG. 1 is a plan view showing a lighting module according to a first embodiment of the invention, FIG. 2 is a side cross-sectional view taken along line A-A of the lighting module of FIG. 1, FIG. 3 is a first modified example of the lighting module of FIG. 2, FIG. 4 is a side cross-sectional view taken along line B-B of the lighting module of FIG. 1, FIG. 5 is a side cross-sectional view taken along line C-C of the lighting module of FIG. 1, FIG. 6 is a second modified example of the lighting module of FIG. 2, FIG. 7 is a third modified example of the lighting module of FIG. 2.

Referring to FIGs. 1 to 5, a lighting module 100 may include a circuit board 11, light emitting devices 21 and 31 disposed on the circuit board 11, and resin layer 41 and 43 sealing the light emitting device 21 and 31 on the circuit board 11, a diffusion layer 51 on a first region of the resin layers 41 and 43, and a reflective layer 61 on a second region of the resin layers 41 and 43, a phosphor portion 45 between a first resin portion 41 and a second resin portion 43 of the resin layers 41 and 43. An upper portion of the first region may be a light emission region 70, and an upper portion of the second region may be a non-emission region 72. The light emitting devices 21 and 31 may include a first light emitting device 21 arranged in at least one row and a second light emitting device 31 arranged in at least one row. The resin layers 41 and 43 may include the first resin portion 41 covering the first light emitting device 21 and the second resin portion 43 covering the second light emitting device 31. The phosphor portion 45 may be disposed between the first resin portion 41 and the second resin portion 43.

The lighting module 100 may emit the light emitted from the light emitting devices 21 and 31 as surface light. The lighting module 100 may emit the first light emitted from the first light emitting device 21. The lighting module 100 may convert the wavelength of the second light emitted from the second light emitting device 23 to emit the third light. The lighting module 100 may emit the fourth light by mixing the first and second lights emitted from the first and second light emitting devices 21 and 31. The first to third lights may be lights of different colors. For example, the first light may be white light, the second light may be blue light, the third light may be red or yellow light, and the fourth light may be amber light. The thickness of the lighting module 100 may be 5.5 mm or less from a bottom of the circuit board 11, or a range of 4.5 mm to 5.5 mm, or a range of 4.5 mm to 5 mm. The thickness of the lighting module 100 may be a linear distance form a lower surface of the circuit board 11 to the uppermost surface of the light module. Since the lighting module 100 has a thickness of 5.5 mm or less, it may be provided as a flexible and slim surface light source module. When the thickness of the lighting module 100 is thinner than the above range, the light diffusion space is reduced and a hot spot may be generated. The embodiment provides a thickness of 5.5 mm or less or 5 mm or less of the lighting module 100 to provide a module capable of a curved structure, thereby reducing design freedom and spatial restrictions. The circuit board 11 may include a connector (not shown) in part to supply power to the light emitting devices 21 and 31. The lighting module 100 may be applied to a front lighting or an indoor lighting in various lamp devices required for lighting, for example, a lamp for a moving object or a lamp for a vehicle. For example, the lighting module 100 may be applied to a daytime running lamp, a headlamp, a fog lamp, or a direction indicator lamp.

In the lighting module 100, the circuit board 11 may function as a base member or a support member positioned under the light emitting devices 21 and 31 and the resin layers 41 and 43. The circuit board 11 includes a printed circuit board (PCB). The circuit board 11 may include, for example, at least one of a resin-based printed circuit board, a metal core PCB, a flexible PCB, a ceramic PCB, or an FR-4 board. The circuit board 11 may include, for example, a flexible PCB or a rigid PCB. The upprt surface of the circuit board 11 may have an X-axis and Y-axis plane, and the thickness of the circuit board 11 may be a height in the Z direction orthogonal to X direction and the Y direction. Here, the X direction may be a first direction, the Y direction may be a second direction orthogonal to the X direction, and the Z direction may be a third direction orthogonal to the X direction and the Y direction. The circuit board 11 includes a wiring layer (not shown) thereon, and the wiring layer may be electrically connected to the light emitting devices 21 and 31. A reflective member or a protective layer disposed on the circuit board 11 may protect the wiring layer. Each of the plurality of first and second light emitting devices 21 and 31 may be connected in series, parallel, or series-parallel by a wiring layer of the circuit board 11. Each of the plurality of first and second light emitting devices 21 and 31 may have two or more groups connected in series or parallel, or between the groups connected in series or parallel. The protective layer may include a member having a solder resist material, and the solder resist material is a white material and may reflect incident light. The thickness of the circuit board 11 may be 0.5 mm or less, for example, in the range of 0.3 mm to 0.5 mm. Since the thickness of the circuit board 11 is provided thin, the thickness of the lighting module may not be increased. Since the circuit board 11 has a thickness of 0.5 mm or less, the circuit board may support a flexible module.

As shown in FIGs. 3 and 6, the lighting module 100 may include a reflective member 15 disposed on the upper surface of the circuit board 11. The reflective member 15 may reflect light traveling toward the upper surface of the circuit board 11. The reflective member 15 may be attached to the upper surface of the circuit board 11 or may be disposed between the circuit board 11 and the resin layers 41 and 43. An adhesive layer, for example, a material such as UV adhesive, silicone, or epoxy, may be formed between the reflective member 15 and the circuit board 11. The reflective member 15 may be provided as a film made of any one of a resin material, transparent PET, white polyethylene terephthalate (PET), and an Ag sheet. A reflective dot may be disposed on the reflective member 15 to reflect incident light. The reflective dots may include ink, for example, may be printed on a material including any one of TiO₂, CaCO₃, BaSO₄, Al₂O₃, Silicon, and PS. Here, the reflective member 15 has an open region, and the first and second light emitting devices 21 and 31 may be disposed through the open region. The reflective member 15 may be formed on the entire upper surface of the circuit board 11, or may be disposed under a region of the first resin portion 41 or a region of the second resin portion 43 of the circuit board 11. As another example, the circuit board 11 may include a transparent material. When the circuit board 11 made of the transparent material is provided, light emitted from the light emitting devices 21 and 31 may be emitted in an upper surface direction and a lower surface direction of the circuit board 11.

The light emitting devices 21 and 31 may be arranged in a plurality of rows and/or columns on the circuit board 11. The first light emitting devices 21 may be arranged in one row or two or more rows on the circuit board 11. A plurality of the first light emitting devices 21 may be arranged in the second direction Y, and at least one of the first light emitting devices 21 may be arranged in the first direction X. The second light emitting device 31 may be arranged in one row or two or more rows on the circuit board 11. A plurality of the second light emitting devices 31 may be arranged in the second direction Y, and at least one may be arranged in the first direction X. The first and second light emitting devices 21 and 31 arranged in the second direction may face each other in the first direction or may be arranged in a zigzag shape.

The first light emitting device 21 may vertically overlap the first resin portion 41 and the diffusion layer 51. The second light emitting device 31 may vertically overlap the second resin portion 43 and the reflective layer 61. The first light emitting device 21 may be disposed in the first resin portion 41 or may be sealed to the first resin portion 41. The second light emitting device 31 may be disposed in the second resin portion 43 or sealed to the second resin portion 43. The first light emitting device 21 may include a first light emitting chip 23 and a wavelength conversion layer 24 covering the first light emitting chip 23. A plurality of pads may be exposed at a lower portion of the first light emitting chip 23, and light may be emitted through an upper surface and a side surface of the first light emitting chip 23. The wavelength conversion layer 24 wavelength-converts some light emitted from the first light emitting chip 23. The wavelength conversion layer 24 may be disposed on an upper surface and/or a plurality of side surfaces of the first light emitting chip 23. Accordingly, the first light emitting device 21 emits first light in which the light emitted from the first light emitting chip 23 and the light converted by the wavelength conversion layer 24 are mixed. The first light emitting chip 23 may be provided as a blue LED chip. The first light emitting chip 23 may be provided in the form of a flip chip, a vertical chip or a horizontal chip. The wavelength conversion layer 24 may include at least one or two or more of red, yellow, and green phosphors. The thickness of the wavelength conversion layer 24 may be 200 micrometers or less, for example, in the range of 100 to 200 micrometers. The thickness of the first light emitting chip 23 may be 0.3 mm or less. The second light emitting device 31 may include a second light emitting chip. The second light emitting chip may emit at least one of blue, green, and red light. The second light emitting chip may emit, for example, blue light. The second light emitting device 31 may be provided in a structure in which a wavelength conversion layer is not formed on the surface of the second light emitting chip. The second light emitting chip may be provided in the form of a flip chip, a vertical chip or a horizontal chip. The first light emitting device 21 may emit white light, and the second light emitting device 31 may emit blue light.

As shown in FIG. 2, a distance D1 between the first and second light emitting devices 21 and 31 may be 3 mm or more, for example, in a range of 3 mm to 5 mm. When the distance D1 between the first and second light emitting devices 21 and 31 is smaller than the above range, heat dissipation efficiency may be reduced, and when larger than the above range, the module size may be increased. As shown in FIG. 4, the distance D3 between the first light emitting devices 21 may be equal to or smaller than the distance between the second light emitting devices 31. The distance D3 between the first and second light emitting devices 21 and 31 may vary depending on the required amount of light.

At least one layer or two or more layers of a resin material disposed on the circuit board 11 may be disposed. At least one layer or two or more layers of a resin material may be formed on the first light emitting device 21. At least one layer or two or more layers of a resin material may be formed on the second light emitting device 31. The resin layers 41 and 43 may include the first resin portion 41 on the first light emitting device 21 and the second resin portion 43 on the second light emitting device 31. The first resin portion 41 may be made of a transparent resin material, for example, a resin material such as UV (ultra violet) resin, silicone, or epoxy. The first resin portion 41 may be a layer including or not including a diffusion agent. The second resin portion 43 may be made of a transparent resin material, for example, a resin material such as UV resin, silicone, or epoxy. The second resin portion 43 may be a layer including a diffusion agent or a layer not including a diffusion agent.

Each of the first and second resin portions 41 and 43 may have a length in the second direction Y greater than widths W1 and W2 in the first direction X. The length of the second direction Y may be three times or more as compared to the widths W1 and W2 of the first direction X. The first and second resin portions 41 and 43 may have the same length in the second direction Y. The widths W1 and W2 of the first and second resin portions 41 and 43 in the first direction X may be different from each other. For example, the width W1 of the first resin portion 41 may be different from the width W2 of the second resin portion 43. For example, the width W1 of the first resin portion 41 may be at least twice the width W2 of the second portion 43. The width W2 of the second resin portion 43 may be 1/2 times or less the width W1 of the first resin portion 41. The first resin portion 41 is a light emission region, and the width W1 of the first resin portion 41 may be 5 mm or more, for example, in a range of 5 mm to 15 mm or 5 mm to 10 mm. When the width W1 of the first resin portion 41 is smaller than the above range, the lighting function may be deteriorated. The width W2 of the second resin portion 43 may be 3 mm or less, for example, in a range of 1.5 mm to 3 mm or 1.5 mm to 2.5 mm. When the width W2 of the second resin portion 43 is smaller than the above range, the wavelength conversion efficiency of the lights emitted from the second light emitting device 31 may be reduced. The first light emitting device 21 may have a width smaller than the width W1 of the first resin portion 41 and may be disposed in the first resin portion 41, and the second light emitting device 31 may be disposed in the second resin portion 43 and may have a width smaller than the width W2 of the second resin portion 43. The distance D2 between a first side surface S1 of the first resin portion 41 and the first light emitting device 21 may be 2.5 mm or more, for example, in the range of 2.5 mm to 3.5 mm. When the distance D2 between the first side surface S1 of the first resin portion 41 and the first light emitting device 21 is smaller than the above range, light loss through the first side surface S1 may increase. The distance K1 between the first light emitting device 21 and an inner surface S11 of the first resin portion 41 may be 3.5 mm or less, for example, in the range of 2.5 mm to 3.5 mm, and when it is less than the above range, heat dissipation efficiency may be reduced or the wavelength conversion efficiency of the first light may be increased.

The second resin portion 43 may be provided without a phosphor. That is, since the width W2 of the second resin portion 43 is not large, when a phosphor is added therein, the wavelength conversion efficiency of the second light may be reduced or the light extraction efficiency may be reduced. Accordingly, the second resin portion 43 may be provided without a phosphor.

The first resin portion 41 and the second resin portion 43 may have the same thickness T1. The thickness T1 of the first resin portion 41 may be the same as the maximum thickness of the second resin portion 43. As shown in FIG. 7, the thickness T1 of the first resin portion 41 may be thicker than the minimum thickness of the second resin portion 43. The thickness T1 of the first and second resin portions 41 and 43 may be 4 mm or less, for example, in the range of 1.8 mm to 4 mm or in the range of 1.8 mm to 3.5 mm. Since the thickness T1 of the first and second resin portions 41 and 43 is provided within the above range, the module may be provided as a flexible module, and light extraction efficiency and light distribution may be improved. An area of the upper surface of the first resin portion 41 may be larger than an area of an upper surface of the second resin portion 43. The upper surface area of the first resin portion 41 may be twice or more of the upper surface area of the second resin portion 43. The upper surface of the first resin portion 41 may be provided as a surface from which light is emitted. The width of the lower surface of the first resin portion 41 may be the same as the width (e.g., W1) of the upper surface. The upper surface of the first resin portion 41 may include a flat plane or a concave or convex curved surface. The upper surface of the first resin portion 41 may include an uneven pattern, but is not limited thereto. In the lighting module 100, the first side S1 is the outer side of the first resin portion 41, and light may be emitted. The region of the first side surface S 1 may be a region blocked by a housing or a bracket.

The phosphor portion 45 may be disposed in the resin layers 41 and 43. The phosphor portion 45 may be disposed between the first resin portion 41 and the second resin portion 43. The phosphor portion 45 may include a red phosphor and/or a yellow phosphor. A phosphor may be added to the phosphor portion 45 in a transparent resin, and the resin may be made of UV resin, silicone, or an epoxy material. The resin of the phosphor portion 45 may be the same material as the resin of the first and second resin portions 41 and 43. The phosphor content of the phosphor portion 45 may be 20 wt% or more, for example, in the range of 20 wt% to 98 wt% or 50 wt% to 98 wt%. The phosphor portion 45 may have a phosphor content in which the second light emitting device 31 is not visible or a hot spot is not generated when viewed from the diffusion layer 51. The phosphor portion 45 converts the wavelength of the second light emitted from the second light emitting device 31 to emit the third light. The third light may be emitted as a third light having a changed wavelength rather than a color obtained by mixing the second light and the light having a wavelength converted by the phosphor. That is, the phosphor portion 45 may have a higher extraction efficiency of wavelength-converted light than an extraction efficiency of mixed-colored light. As another example, in the phosphor portion 45, phosphors may be attached to the inner surface of the first resin portion 41 or the inner surface of the second resin portion 43 in the form of dots.

The height of the phosphor portion 45 may be equal to the thickness T1 of the first resin portion 41 and/or the second resin portion 43 in the vertical direction. The width of the phosphor portion 45 as a thickness in the first direction X may be 500 micrometers or less, for example, in the range of 200 *µ*m to 500 *µ*m or 200 *µ*m to 350 *µ*m. The width of the phosphor portion 45 may vary depending on the diameter of the phosphor. The area of the vertical surface of the phosphor portion 45 may be the same as the area of the inner surface of the first resin portion 41 and/or the area of the inner surface of the second resin portion 43. The phosphor portion 45 is disposed between the inner surface of the first resin portion 41 and the inner surface of the second resin portion 43, and the first resin portion 41 and may block inner side surfaces of the first resin portion 41 and the second resin portion 43 from contacting each other. As another example, a phosphor layer may be further formed between at least one of the first reflective portion 61A and the second reflective portion 61B of the reflective layer 61 and the second resin portion 43. The color conversion efficiency of light traveling to the first resin portion 41 may be improved by the layer having such a phosphor.

The diffusion layer 51 may be disposed on the first resin portion 41. The diffusion layer 51 may be adhered or attached to the upper surface of the first resin portion 41. The diffusion layer 51 may be provided with the same area as the upper surface of the first resin portion 41, or may be provided with an area larger than the upper surface area of the first resin portion 41. On the first side surface S1 of the lighting module 100, the side surface of the first resin portion 41 and the side surface of the diffusion layer 51 may be disposed in the same plane. On the third and fourth side surfaces S3 and S4 of the lighting module 100, both side surfaces of the diffusion layer 51 and both side surfaces of the first resin portion 41 may be disposed on the same plane. As another example, a portion of the diffusion layer 51 may protrude in the direction of at least one side or two side surfaces among the side surfaces S1, S3, and S4 of the first resin portion 41. The diffusion layer 51 may include a diffusion agent in a transparent resin material. The diffusion layer 51 may diffuse incident light. The diffusing agent may include at least one of a poly methyl meth acrylate (PMMA) series, TiO₂, SiO₂, Al₂O₃, and silicon series. The upper surface of the diffusion layer 51 may be a light emitting surface S0. That is, the light emitting surface S0 may serve as the light emission region 70.

The reflective layer 61 may be formed of a reflective member made of a metal or non-metal material. The metal material may be formed of a material such as aluminum or silver, and the non-metal material may be provided as at least one of a resin material, a transparent PET, and a white polyethylene terephthalate (PET) material. The reflective layer 61 may include at least one of TiO₂, CaCO₃, BaSO₄, Al₂O₃, Silicon, and PS inside the resin. The reflective layer 61 may reflect incident light. The reflective layer 61 may be formed on the upper surface and outer side surfaces of the second resin portion 43. The reflective layer 61 may include a first reflective portion 61A disposed on an upper surface of the second resin portion 43 and a second reflective portion 61B disposed on an outer side surface of the second resin portion 43. The second reflective portion 61B may extend in a vertical direction from the first reflective portion 61A. The reflective layer 61 may be disposed outside the second light emitting device 31 to block leakage of light emitted from the second light emitting device 31. The outer surface S2 of the second reflective portion 61B may face the first side surface S1. The reflective layer 61 may vertically overlap the phosphor portion 45. The reflective layer 61 may be in contact with the upper surface of the second resin portion 43. The reflective layer 61 may be in contact with an upper surface of the second resin portion 43 and an upper end of the phosphor portion 45. When the upper end of the phosphor portion 45 is in contact with the diffusion layer 51, there may be a problem in that light that is not wavelength-converted may leak through the diffusion layer 51. Accordingly, the upper end of the phosphor portion 45 may be disposed at a position in contact with the lower surface of the reflective layer 61. The reflective layer 61 may be in contact with the diffusion layer 51. An interface between the reflective layer 61 and the diffusion layer 51 may extend from one surface of the phosphor portion 45. One surface of the phosphor portion 45 may be a surface in contact with the inner surface of the first resin portion 41.

In the lighting module 100, the light emission region 70, which is a first region, is an upper portion of the first resin portion 41, and the non-emission region 72, which is a second region, is an upper portion of the second resin portion 43. The light emission region may be a region from which light is emitted. The non-emission region may be a region in which light is blocked or reflected and is not emitted to the outside. That is, the lighting module 100 may emit light of at least two colors or light of three colors or more through the light emission region 70, and the second light emitting device 31 may be provided in a structure that is not exposed to the outside.

The lighting module 100 according to the first embodiment may be provided to the front module of the moving body. For example, the front module is a front light of a vehicle lamp, and may be a headlamp, a fog lamp, or a turn indicator lamp. When the lighting module is in the first lighting mode, the first light emitting device 21 is driven to emit the first light to the diffusion layer 51 or the light emission region, and in this case, the second light emitting device 31 may be in a turned off state. In the second lighting mode, the second light emitting device 31 is driven and the first light emitting device 21 is turned off, and the second light emitted from the second light emitting device 31 is emitted by the phosphor portion 45 and may be wavelength-converted into third light and emitted to a light emission region. The first light may be white light, and the second light may be red or yellow light. That is, white light or red light (or yellow light) may be illuminated according to the first and second lighting modes. Also, in the third lighting mode, the first light emitting device 21 and the second light emitting device 31 are turned on, and the first and third lights may be mixed to emit yellow light.

As shown in FIG. 3, the reflective member 15 may contact the first resin portion 41 and the second resin portion 43. The reflective member 15 may reflect the light incident from the lower portions of the first and second resin portions 41 and 43. A portion of the reflective member 15 may be disposed between the second light emitting device 31 and the reflective layer 61. A portion of the reflective member 15 may extend from the first resin portion 41 to the lower portion of the second resin portion 43 through the lower end of the phosphor portion 45.

As shown in FIG. 6, an outer portion 15A of the reflective member 15 may be exposed to the outside of the lower end of the reflective layer 61. In this case, the reflective layer 61 is made of a resin or metal material and may be adhered to the outer portion 15A of the reflective member 15. As shown in FIG. 7, the upper surface of the second resin portion 43 may include a concave curved portion R1, a convex curved portion, or a light reflection pattern. Accordingly, by reflecting the incident light in a different direction, it is possible to improve light extraction efficiency into the light emission region. The curved portion R1 may provide the first reflective portion 61A of the reflective layer 61 as a curved surface, thereby improving reflection efficiency. The curved portion R1 may be provided with a height that gradually decreases from the upper end of the phosphor portion 45 adjacent to the first resin portion 41.

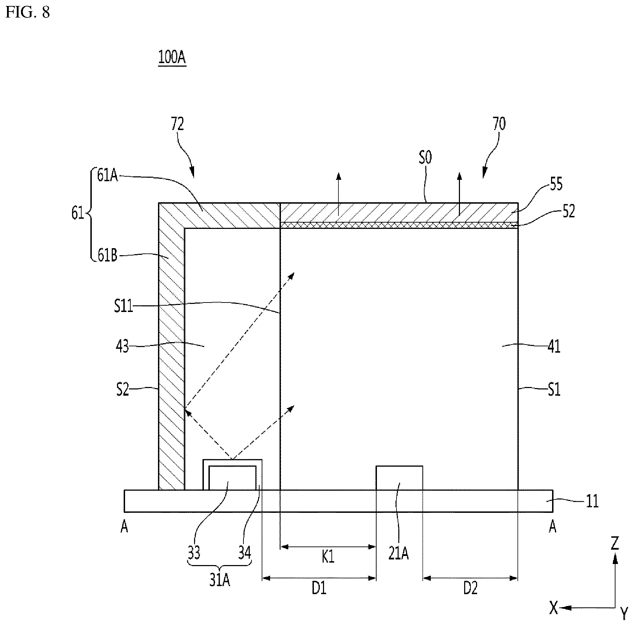

A lighting module according to a second embodiment will be described with reference to FIGS. 8 to 11. The lighting module according to the second embodiment has the same configuration as that of the first embodiment with reference to the first embodiment, and may include the configuration and description of the first embodiment. The lighting module according to the second embodiment may be applied to a rear lamp of a moving object or vehicle, for example, at least one of an auxiliary brake light, a tail light, a brake light, a reversing light, and a tail light.

Referring to FIG. 8, the lighting module 100A may include a circuit board 11, a plurality of light emitting devices including a first light emitting device 21A and a second light emitting device 31A, a resin layer having a first resin portion 41 and a second resin portion 43, a phosphor layer 52, an ink layer 55, and a reflective layer 61. The first light emitting device 21A may be an LED chip emitting blue light, and the second light emitting device 31A may be a device emitting white light. The second light emitting device 31A may include a second light emitting chip 33 emitting blue light and a wavelength conversion layer 34 thereon. The second light emitting device 31A may emit white light by mixing blue light with wavelength-converted light by the wavelength conversion layer 34. The distance D1 between the first light emitting device 21A and the second light emitting device 31A may be greater than the distance D2 between the first light emitting device 21A and the first side surface S1 of the first resin portion 41. The distance K1 between the first light emitting device 21A and the second resin portion 43 may be 3.5 mm or less, for example, in the range of 2.0 mm to 3.5 mm, and may be smaller than the distance K1 in the first embodiment. The first light emitting device 21A may be disposed under the first resin portion 41, and the second light emitting device 31A may be disposed under the second resin portion 43. The width, length, and thickness of the first resin portion 41 and the second resin portion 43 will be described with reference to FIGS. 1 and 2. The first and second resin portions 41 and 43 may be in contact with each other. The interface S11 between the first resin portion 41 and the second resin portion 43 may be disposed at an interface between the reflective layer 61 and the phosphor layer 52 or may be disposed under the reflective layer 61.

The reflective layer 61 may be disposed on an upper surface and an outer side surface of the second resin portion 43.

The phosphor layer 52 may be disposed on the upper surface of the first resin portion 41. An ink layer 55 may be disposed on the phosphor layer 52. The phosphor layer 52 may be defined as a resin layer having a phosphor. The ink layer 55 may be defined as a resin layer having ink particles. The first resin portion 41, the phosphor layer 52, and the ink layer 55 may vertically overlap. The upper surface area of the first resin portion 41 may be the same as the lower surface area of the phosphor layer 52. The upper surface area of the phosphor layer 52 may be the same as the lower surface area of the ink layer 55. Accordingly, the light traveling through the first resin portion 41 may be wavelength-converted by the phosphor layer 52, and may be emitted through the ink layer 55.

The phosphor layer 52 may include at least one of a red or yellow phosphor. As another example, the phosphor layer 52 may include at least one of red, green, yellow, and blue phosphors. When the incident light is incident on the first light emitted from the first light emitting device 21A, the phosphor layer 52 converts wavelength to emit red light, and the light emitted from the second light emitting device 31A is incident Then, the wavelength may be converted and emitted as yellow light. As another example, a single resin layer having a phosphor and ink particles may be formed on the first resin portion 41. As another example, a single resin layer having a diffusing agent, a phosphor, and ink particles may be formed on the first resin portion 41.

The ink layer 55 and the phosphor layer 52 may contact the reflective layer 61. At least one or both of the ink layer 55 and the phosphor layer 52 may be disposed to vertically overlap the reflective layer 61. The ink layer 55 and the phosphor layer 52 may enhance the adhesion between the ink layer 55 and the phosphor layer 52 and the reflective layer 61. The upper surface of the ink layer 55 may be a light emitting surface S0. That is, the light emitting surface S0 may serve as the light emission region 70 which is the first region. The phosphor content in the phosphor layer 52 may be 50 wt% or less, for example, in the range of 10 wt% to 50 wt% or 10 wt% to 30 wt%. The phosphor layer 52 may have a phosphor content in which the first and second light emitting devices 21A and 31A are not visible or hot spots are not generated when viewed from the ink layer 55. Here, the phosphor content of the phosphor layer 52 may be lower than that of the first embodiment because light transmittance may be lowered by the ink layer 55 on the surface. The ink particles added to the ink layer 55 may include at least one of metal ink, UV ink, and curing ink. The size of the ink particles may be smaller than the size of the phosphor. The surface color of the ink particles may be any one of green, red, yellow, and blue. The ink types may be selectively applied among PVC (Poly vinyl chloride) ink, PC (Polycarbonate) ink, ABS (acrylonitrile butadiene styrene copolymer) ink, UV resin ink, epoxy ink, silicone ink, PP (polypropylene) ink, water-based ink, plastic ink, PMMA (poly methyl methacrylate) ink and PS (Polystyrene) ink. Here, the width or diameter of the ink particles may be 5 µm or less, for example, in the range of 0.05 µm to 1 µm. At least one of the ink particles may be smaller than a wavelength of light. The color of the ink particles may include at least one of red, green, yellow, and blue. For example, the phosphor may emit a red wavelength, and the ink particles may include a red color. For example, the red color of the ink particles may be deeper than the color of the wavelength of the phosphor or light. The ink particles may have a color different from that of the light emitted from the light emitting devices 21A and 31A. The ink particles may have an effect of blocking or blocking incident light. The ink particles added to the ink layer 55 may be added in a range of 12 wt% or less, for example, in the range of 4 wt% to 12 wt%. A decrease in wavelength conversion efficiency may be prevented by the content of the phosphor, and a color difference in a surface color may be reduced by the content of the ink particles and a hot spot may be reduced. The phosphor content may be 3wt% or more than the content of the ink particles, or may be added in a range of 3wt% to 13wt%. The color of the surface of the ink layer 55 may be provided as the color of ink particles. Transmission of light may be suppressed by these ink particles, and hot spots may be lowered.

The lighting module 100A according to the second embodiment is provided with a red surface in the non-light emitting mode, and in the first lighting mode, the first light emitting device 21A is driven, and the second light emitting device 31A is turned off and red light may be emitted through the ink layer 55. In the second lighting mode, the first light emitting device 21A is turned off, the second light emitting device 31A is turned on, and yellow light may be emitted through the ink layer 55.

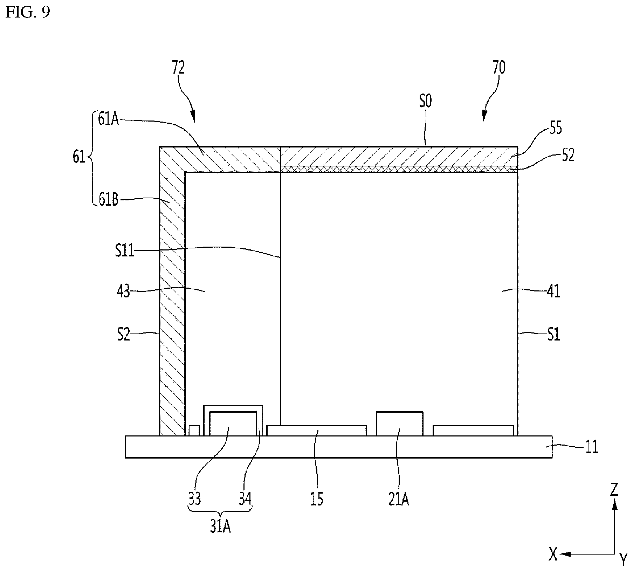

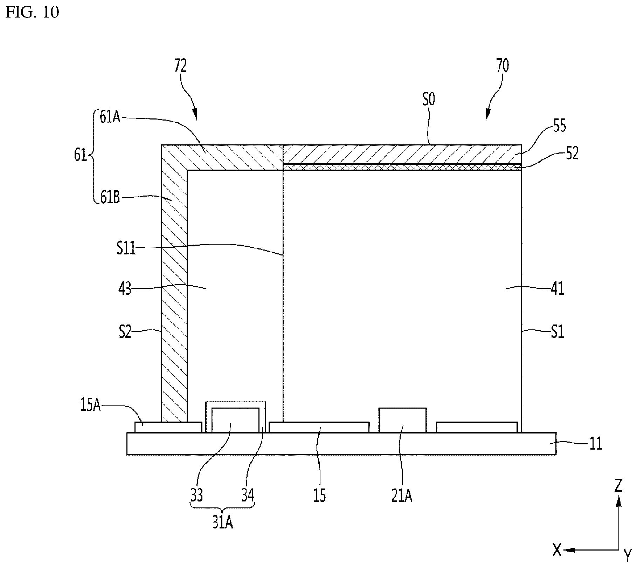

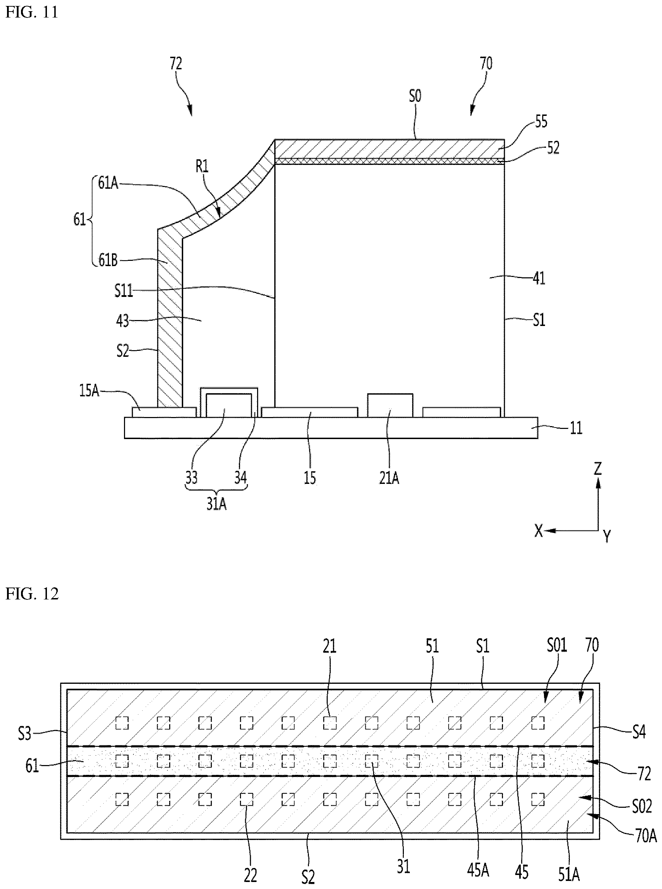

As shown in FIG. 9, a reflective member 15 may be disposed between the upper surface of the circuit board 11 and the first resin portion 41 and between the upper surface of the circuit board 11 and the second resin portion 43. The reflective member 15 may contact the first and second resin portions 41 and 43. The reflective member 15 may be in contact with or spaced apart from the wavelength conversion layer 34. As shown in FIG. 10, the outer portion 15A of the reflective member 15 may protrude or be exposed to the outside through the reflective layer 61. The reflective member 15 may be in contact with the lower surface of the reflective layer 61. As shown in FIG. 11, the upper surface of the second resin portion 43 may include a concave curved portion R1 or a convex curved portion, or may include a light reflection pattern. Accordingly, by reflecting the incident light in a different direction, it is possible to improve light extraction efficiency into the light emission region. The curved portion R1 may provide the first reflective portion 61A of the reflective layer 61 as a curved surface, thereby improving reflection efficiency. The curved portion R1 may be provided at a height that gradually decreases from the upper end of the phosphor layer 52 adjacent to the first resin portion 41.

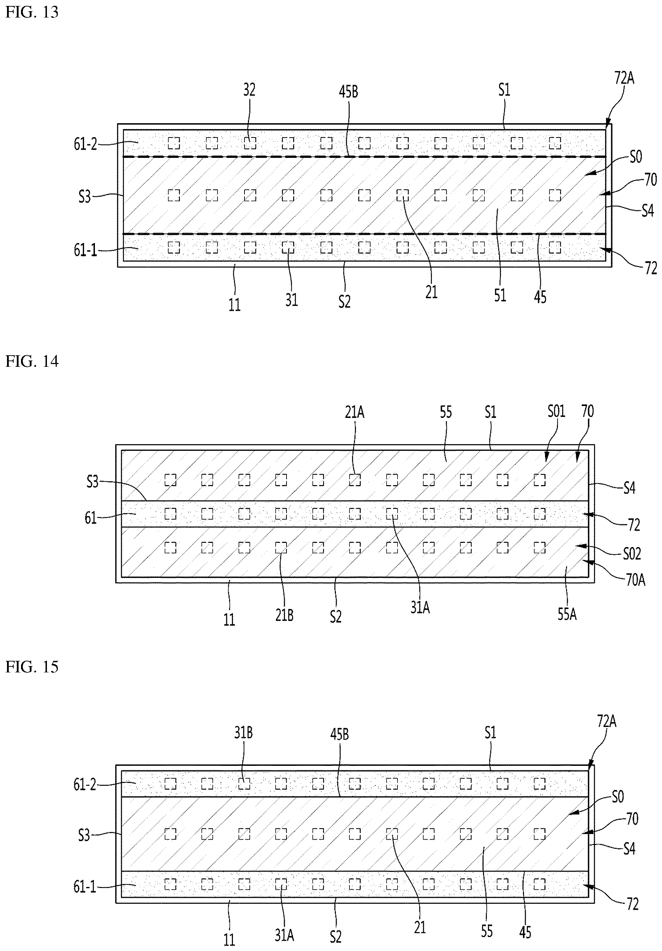

As shown in FIGs. 12 and 13 are modified examples of the first embodiment. As shown in FIGs. 12 and 2, first and second light emission regions 70 and 70A may be disposed as light emitting surfaces S01 and S02 on both sides of the non-emission region 72. That is, the non-emission region 72 may be disposed between the first emission region 70 and the second emission region 70A. The first light emission region 70 and the second light emission region 70A may be provided with the first light emitting devices 21 and 22, the first resin portion 41, and the diffusion layers 51 and 51A disclosed in the first embodiment, respectively. A second light emitting device 31, a second resin portion 43, phosphor portions 45 and 45A, and a reflective layer 61 may be disposed in the non-emission region 72. Here, the phosphor portions 45 and 45A may be disposed at the boundary of the first light emission region 70 with the first resin portion 41 and at the boundary of the second light emission region 70A with the first resin portion 41, respectively.

Referring to FIGs. 13 and 2, the first and second non-emission regions 72 and 72A may be disposed on both sides of the light emission region 70. That is, the light emission region 70 may be disposed between the first non-emission region 72 and the second non-emission region 72A. The first light emitting device 21, the first resin portion 41, and the diffusion layer 51 described in the first embodiment may be provided in the light emission region, respectively. The second light emitting devices 31 and 32, the second resin portion 43, the phosphor portions 45 and 45B and the reflective layers 61-1 and 61-2 may be respectively disposed in the first and second non-emission regions. Here, the phosphor portions 45 and 45B may be disposed to the inner surfaces of the second resin portion 43 of the first non-emission regions 72 and 72A, and disposed on the inner surface of the second resin portions 43 of the second non-emission regions 72 and 72A, respectively.

The lighting mode of the lighting module disclosed in FIGs. 12 and 13 may be the same as the mode of the first embodiment. As an example of another lighting mode, when the first light emitting devices 21 of the first and second light emission regions 70 and 70A emit light of different colors as shown in FIG. 12, for example, The first light emitting device 21 may emit white light, and the first light emitting device 22 of the second light emission region 70A may emit yellow light. As shown in FIG. 13, when the second light emitting devices 31 and 32 of the first and second non-emission regions 72 and 72A emit light of different colors, for example, the second light emitting device of the first non-emission region 72. The light emitting device 31 may emit blue light, and the second light emitting device 32 of the second non-emission region 72A may emit green or yellow light. Here, the plurality of phosphor portions 45, 45A and 45B illustrated in FIGS. 12 and 13 may include phosphors of the same color or phosphors of different colors. Any one of the phosphor portions 45, 45A, and 45B illustrated in FIG. 12 or 13 may be removed.

FIGs. 14 and 15 are modified examples of the second embodiment. As shown in FIGs. 14 and 8, first and second light emission regions 70 and 70A may be disposed on both sides of the non-emission region 72. That is, the non-emission region 72 may be disposed between the first emission region 70 and the second emission region 70A. The first light emitting devices 21 and 21B, the first resin portion 41, the phosphor layer 52 and the ink layer 55 may be provided in each of the first light emission region 70 and the second light emission region 70A. The second light emitting device 31A, the second resin portion 43 and the reflective layer 61 may be disposed in the non-emission region 72. Here, the second resin portion 43 of the non-emission region 72 may be contacted or integrally formed on the first resin portion 41 of the first light emission region 70 and the first resin portion 41 of the second light emission region 70A.

As shown in FIGs. 15 and 8, first and second non-emission regions 72 and 72A may be disposed on both sides of the light emission region 70. That is, the light emission region 70 may be disposed between the first non-emission region 72 and the second non-emission region 72A. The first light emitting device 21, the first resin portion 41, the phosphor layer 52, and the ink layer 55 described in the second embodiment may be provided in the light emission region 70, respectively. The second light emitting devices 31A and 31B, the second resin portion 43 and the reflective layers 61-1 and 61-2 may be respectively disposed in the first and second non-emission regions 72 and 72A. Here, both side surfaces of the first resin portion 41 of the light emission region 70 may be in contact with each of the inner side surfaces of the second resin portion 43 of the first non-emission region 72 and the inner surfaces of the second resin portion 43 of the second non-emission region 72A.

The lighting mode of the lighting module disclosed in FIGS. 14 and 15 may be the same as the mode of the second embodiment. As an example of another illumination mode, as shown in FIG. 14, when the first light emitting devices 21A and 21B of the first and second light emission regions 70 and 70A emit light of different colors, for example, the first light emitting device 21A of the first light emission region 70 may emit blue light, and the first light emitting device 21B of the second light emission region 70A may emit green or yellow light. As shown in FIG. 15, when the second light emitting devices 31A and 31B of the first and second non-emission regions 72 and 72A emit light of different colors, for example, the second light emitting device of the first non-emission region 72. The light emitting device 31A may emit white light, and the second light emitting device 31B of the second non-emission region 72A may emit yellow light. Here, the plurality of phosphor layers 52 illustrated in FIGS. 14 and 15 may include phosphors of the same color or phosphors of different colors. Any one of the phosphor layers 52 disclosed in FIG. 14 or FIG. 15 may be removed.

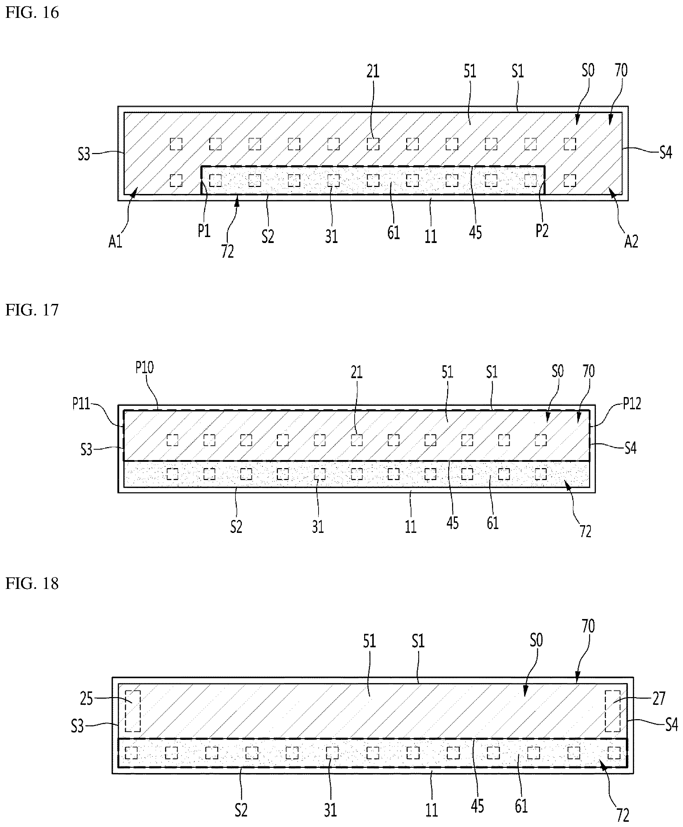

FIG. 16 is a modified example of the lighting module according to the first and second embodiments of the invention.

Referring to FIG. 16, the sub-regions A1 and A2 of the light emission region 70 may extend to both sides of the non-emission region 72. Alternatively, the non-emission region 72 may extend to both sides of the emission region 70. As in the first embodiment, the phosphor portion 45 disposed under the non-emission region 72 may be disposed along the light emission region 70 and the sub-regions A1 and A2, for example, the first and second phosphor portions 45 and 45A may be further disposed in the sub-regions A1 and A2 on both sides of the light emission region 70. In this case, the reflective layer 61 may be disposed only on the second side surface S2 of the second resin portion 43. Alternatively, a layer having a phosphor may be further disposed on the second side surface S2 outside the second resin portion 43. As in the second embodiment, when the ink layer 55 is disposed on the first resin portion 41 in the light emission region 70, A phosphor layer 52/ink layer 55 may be stacked along the reflective layer 61 disposed on both sides of the non-emission region 72. When the ink layer 55 is disposed on the first resin portion 41 of the light emission region 70, the phosphor layer 52/ink layers 55 may be stacked along the reflective layers 61 disposed on both sides of the non-emission region 72.

FIG. 17 is a modified example of the lighting module according to the first and second embodiments of the invention.

Referring to FIG. 17, the light emission region 70 may face the non-emission region 72. A phosphor portion 45 is disposed on the inner side surface of the first resin portion 41, and extension portions P10, P11, and P12 of the phosphor portion 45 are formed along each side surface S1, S3, S4 of the first resin portion 41. Alternatively, the ink layer 55 may extend on the inner surface and each side surface of the first resin portion 41. For example, when the phosphor portion 45 is disposed, the phosphor portion 45 may be disposed on a boundary portion between the first resin portion 41 and the second resin portion 43, and disposed on the outer side surfaces S1, S3, and S4 of the first resin portion 41, respectively. For example, when the ink layer 55 is disposed, the ink layer 55 may be disposed on the upper surface and each side surface S1, S3, and S4 of the first resin portion 41.

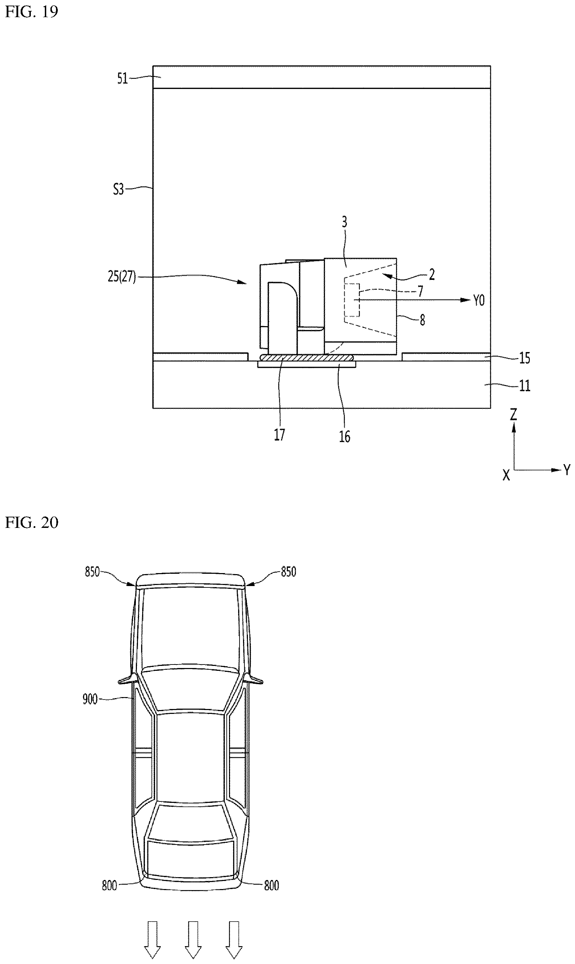

FIGs. 18 and 19 are other examples of the invention, FIG. 18 is a modification of the first light emitting device in the lighting module according to the first and second embodiments, and FIG. 19 is an example of a cross-sectional side view of a lighting module having the first light emitting device of FIG. 18.

Referring to FIGs. 18 and 19, a plurality of first light emitting devices 25 and 27 are disposed to be spaced apart from each other in the first resin portion 41 of the light emission region 70, and the second light emitting devices 31 may be arranged in at least one row in the second resin portion 43. The plurality of first light emitting devices 25 and 27 may be disposed adjacent to the third side surface S3 and the fourth side surface S4 which are both sides of the light emission region 70. The plurality of first light emitting devices 25 and 27 may be implemented as a side view package, and may provide the light in the inner direction of the first resin portion 41, that is, in the center direction between the first light emitting devices 25 and 27, is provided. As another example, the second light emitting devices 31 may be respectively disposed as a side view package or a top view package at positions spaced apart from each other. the first light emitting devices 25 and 27 are bonded to a lead frame by the bonding member 17 to the upper electrode 16 of the circuit board 11, and emits light in one direction Y0. The first light emitting device 21 may include a light emitting chip 7 in the cavity 2 of the body 3 and a molding portion 8 covering the light emitting chip 7 in the cavity 2. A phosphor may be included in the molding portion 8. The molding portion 8 may be a wavelength conversion layer disclosed in the embodiment. The above-described lighting modules 100 and 100A may be applied to a vehicle lamp, a display device having a micro-LED, or various lighting devices. As the above-described lighting module provides a surface light source, an additional inner lens may be eliminated. When viewed from the side, the lighting modules 100 and 100A may be provided in a flat plate shape, a convex curved shape or a concave curved shape, or a convex/concave shape. When viewed from a top view, the lighting module may have a bar shape such as a stripe, a polygonal shape, a circular shape, an elliptical shape, a shape having a convex side, or a shape having a concave side.

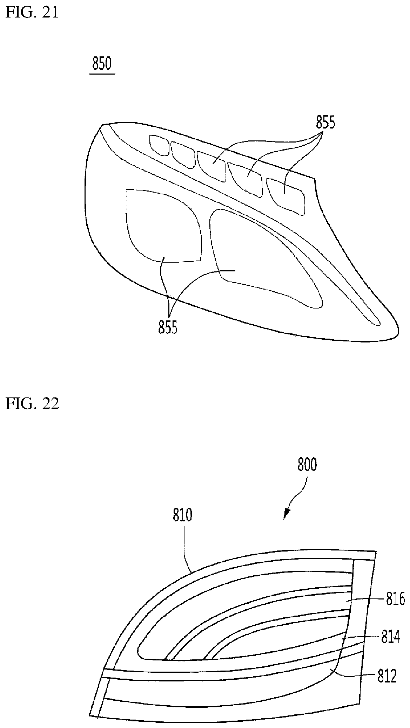

FIG. 20 is a plan view of a vehicle to which a lamp having a lighting module according to an embodiment is applied, FIG. 21 is a view showing an example of a front lamp in the vehicle of FIG. 20, and FIG. 22 is a view showing a rear lamp of the vehicle of FIG. 20.

Referring to FIGs. 20 to 22, in the vehicle 900, the front lamp 850 may include one or more lighting modules 855, and individually control the driving timing of these lighting modules 855 to function as a normal headlight as well as a welcome when the driver opens the vehicle door, and it may also provide additional functions, such as a light or a celebration effect. The lamp may be applied to a daytime running lamp, a high beam, a low beam, a fog lamp or a turn signal lamp.

In addition, the tail lamp 800 of the vehicle 900 may include a first lamp unit 812, a second lamp unit 814, a third lamp unit 816, and a housing 810. Here, the first lamp unit 812 may be a lighting module serving as a turn indicator, the second lamp unit 814 may be a lighting module serving as a sidelight, and the third lamp unit 816 may be a lighting module serving as a brake light, but is not limited thereto. At least one or all of the first to third lamp units 812, 814, and 816 may include the lighting module disclosed in the embodiment. The housing 810 accommodates the first to third lamp units 812, 814, and 816, and may be made of a light-transmitting material. In this case, the housing 810 may have a curve according to the design of the vehicle body, and the first to third lamp units 812, 814, and 816 may implement a surface light source that may have a curved surface according to the shape of the housing 810. Such a vehicle lamp may be applied to a turn signal lamp of a vehicle when the lamp unit is applied to a tail lamp, a brake lamp, or a turn signal lamp of a vehicle.

Features, structures, effects, etc. described in the above embodiments are included in at least one embodiment of the invention, and are not necessarily limited to only one embodiment. Furthermore, features, structures, effects, etc. illustrated in each embodiment can be combined or modified for other embodiments by those of ordinary skill in the art to which the embodiments belong. Accordingly, the contents related to such combinations and modifications should be interpreted as being included in the scope of the invention. In addition, although the embodiment has been described above, it is merely an example and does not limit the invention, and those of ordinary skill in the art to which the invention pertains are exemplified above in a range that does not depart from the essential characteristics of the present embodiment. It can be seen that various modifications and applications that have not been made are possible. For example, each component specifically shown in the embodiment can be implemented by modification. And differences related to such modifications and applications should be construed as being included in the scope of the invention defined in the appended claims.

## Claims

1. A lighting module comprising:
a circuit board;
a plurality of first light emitting devices disposed on a first region of the circuit board;
a plurality of second light emitting devices disposed on a second region of the circuit board;
a resin layer including a first resin portion sealing the plurality of first light emitting devices and a second resin portion sealing the plurality of second light emitting devices;
a phosphor portion disposed between the first resin portion and the second resin portion;
a diffusion layer disposed on the first resin portion; and
a reflective layer disposed on an upper surface and an outer side surface of the second resin portion,
wherein each of the plurality of first light emitting devices and the plurality of second light emitting devices has at least one row in a first direction and is arranged in a second direction orthogonal to the first direction, and
wherein a width of the second resin portion in the first direction is smaller than a width of the first resin portion.

2. The lighting module of claim 1, wherein the first light emitting device is a first light emitting chip for emitting blue light; and a wavelength conversion layer disposed on a surface of the first light emitting chip, and
wherein the first light emitting device emits white light.

3. The lighting module of claim 2, wherein the second light emitting device emits blue light, and
wherein the phosphor portion covers between the first resin portion and the second resin portion and emits red or yellow light.

4. A lighting module comprising:
a circuit board;
a plurality of first light emitting devices disposed on a first region of the circuit board;
a plurality of second light emitting devices disposed on a second region of the circuit board;
a resin layer including a first resin portion sealing the plurality of first light emitting devices and a second resin portion sealing the plurality of second light emitting devices;
a phosphor layer disposed on the first resin portion;
an ink layer disposed on the phosphor layer; and
a reflective layer disposed on an upper surface and an outer side surface of the second resin portion,
wherein each of the plurality of first light emitting devices and the plurality of second light emitting devices has at least one row in a first direction and is arranged in a second direction orthogonal to the first direction, and
wherein a width of the second resin portion in the first direction is smaller than a width of the first resin portion.

5. The lighting module of claim 4, wherein the first light emitting device emits blue light,
wherein the second light emitting device include a second light emitting chip emitting blue light; and a wavelength conversion layer disposed on the surface of the second light emitting chip, and
wherein the second light emitting device emits white light.

6. The lighting module of claim 5, wherein the phosphor layer comprises a red phosphor, and
wherein the ink layer includes red ink particles.

7. The lighting module of any one of claims 1 to 6, wherein the width of the first resin portion in the first direction is at least twice the width of the second resin portion in the first direction, or in a range of 5 mm to 15 mm.

8. The lighting module of any one of claims 1 to 6, further comprising: a light emission region from which light is emitted on the first resin portion; and a non-emission region from which light is reflected on the second resin portion,
wherein the non-light emission region is respectively disposed on both sides of the light emission region.

9. The lighting module of any one of claims 1 to 6, further comprising: a light emission region from which light is emitted on the first resin portion; and a non-emission region from which light is reflected on the second resin portion,
wherein the light emission region is respectively disposed on both sides of the non-light emission region.

10. The lighting module of any one of claims 1 to 6, comprising a reflective member between the resin layer and the circuit board,
wherein the reflective member is in contact with the reflective layer.

11. A lighting device for a vehicle having a lighting module according to any one of claims 1 to 6.
